Europäisches Patentamt

European Patent Office

Office européen des brevets

(19)

(11) **EP 0 755 122 B1**

(12) **EUROPÄISCHE PATENTSCHRIFT**

(45) Veröffentlichungstag und Bekanntmachung des Hinweises auf die Patenterteilung:
**02.04.2003 Patentblatt 2003/14**

(51) Int Cl.⁷: $H03M\ 13/00$, $H03M\ 13/29$, $H03M\ 13/35$, $H03M\ 13/39$, $H04L\ 1/00$

(21) Anmeldenummer: **96111310.7**

(22) Anmeldetag: **12.07.1996**

(54) **Verfahren und Anordnung zur Bestimmung eines adaptiven Abbruchkriteriums beim iterativen Decodieren multidimensional codierter Information**

Method and device for fixing an adaptive interrupt criterion with iterative decoding of multidimensional coded information

Méthode et dispositif pour déterminer un critère d'interrupteur adaptatif lors du décodage itératif d'information codée de façon multidimensionnelle

(84) Benannte Vertragsstaaten:
**DE ES FR GB IT**

(30) Priorität: **19.07.1995 DE 19526416**

(43) Veröffentlichungstag der Anmeldung:
**22.01.1997 Patentblatt 1997/04**

(73) Patentinhaber: **SIEMENS AKTIENGESELLSCHAFT**
**80333 München (DE)**

(72) Erfinder:
• **Hagenauer, Joachim, Prof.Dr.Ing.**
**82229 Seefeld (DE)**
• **Burkert, Frank**
**80796 München (DE)**

(56) Entgegenhaltungen:
EP-A- 0 511 139        US-A- 3 938 085
US-A- 3 976 863

• **MOHER M: "DECODING VIA CROSS-ENTROPY MINIMIZATION" PROCEEDINGS OF THE GLOBAL COMMUNICATIONS CONFERENCE (GLOBECOM),US,NEW YORK, IEEE, Bd. -, 29. November 1993 (1993-11-29), Seiten 809-813, XP000427921**

**Beschreibung**

Verfahren und Anordnung zur Bestimmung eines adaptiven Abbruchkriteriums beim iterativen Decodieren multidimensional codierter Information

Bei der Übertragung von Information von einem Sender zu einem Empfänger auf gestörten Nachrichtenkanälen treten Fehler auf, die es empfängerseitig zu erkennen und zu korrigieren gilt. Dazu werden bei der Kanalcodierung zusätzlich zu den die Information repräsentierenden Zeichen weitere redundante Kontrollzeichen übertragen.

Die Codiereinrichtung beim Sender leitet bei der Kanalcodierung Kontrollzeichen aus den die Information repräsentierenden Zeichen durch eine entsprechende Codierung ab. Mit Hilfe dieser Kontrollzeichen ist es empfängerseitig möglich, geänderte Informationszeichen zu detektieren und gegebenenfalls zu korrigieren. Für die Kanalcodierung stehen verschiedenartige Codierungsverfahren zur Verfügung. Eines dieser Verfahren ist die multidimensionale Codierung. Zu der dabei verwendeten Codegruppe zählen die von C. Berrou "Near Shannon limit error-correcting and decoding: Turbo-Codes (1)", Proc. ICC '93, May 1993 und C. Berrou, A. Glavieux, "Turbo-Codes: General principles and applications" R. de Gaudenzi and M. Luise (Ed.), Audio and Video Digital Radio Broadcasting Systems and Techniques, Proc. of the 6th Tirrenia Int. Workshop on Digital Communications, pp. 215-226, 1993, beschriebenen parallel verketteten systematischen rekursiven Codes - "Turbo-Codes".

Multidimensionale Codes werden empfangsseitig iterativ decodiert. C. Berrou stellt hierfür für den Fall von zwei systematischen rekursiven Codes in der europäischen Patentanmeldung EP 92 460 011.7 ein iteratives Decodierverfahren vor, ohne jedoch auf adaptive Abbruchkriterien einzugehen. Ein adaptives Abbruchkriterium gestattet es, abweichend von einer vorgegebenen festen Anzahl von Iterationen, die Anzahl der Iterationen flexibel an den Verlauf der Decodierung anzupassen. Statistische Untersuchungen zeigen, daß oft schon nach wenigen Iterationen die decodierten Kontrollzeichen mit hoher Sicherheit bestimmt werden können. Weitere Iterationen tragen nur noch wenig zur Leistungsfähigkeit des Codierverfahrens bei.

Aus M. Moher, "Decoding via Cross-entropy Minimization", Proceedings of GLOBECOM '93, IEEE Global Telecommunications Conference, Vol. 2, Houston, TX, USA, 19.11.-2.12.1993, S. 809-813, ist ein Decodierverfahren zur Decodierung von Produktcodes bekannt, das auf einer Abschätzung der Entropie beruht. Dabei werden die empfangenen Kanalinformationen mit den aus den Paritätsgleichungen (Paritätsbits und Nutzbits) bestimmten Codewörtern verglichen. Je ähnlicher das Decodierergebnis (die bestimmten Codewörter) den Kanalinformationen ist - dabei ist die relative Entropie minimal - umso besser ist die Decodierung. Hierbei dient die relative Entropie als Optimierungskriterium für die Decodierung.

Aus P. Robertson, "Illuminating the structure of code and decoder for parallel concatenated recursive systematic (Turbo) codes", submitted GLOBECOM '94, ist ein adaptives Abbruchkriterium basierend auf einen Vergleich der Rauschvarianz des die Information übermittelnden Kanals mit einem durch ein vorgegebenes Signal-Rausch-Verhältnis und damit einer Fehlerrate bezeichneten Kanal. Ergibt die nach einem Iterationsschritt bestimmte Rauschvarianz einen Wert kleiner als der vorbestimmte, mit einem Signal-Rausch-Verhältnis korrespondierende Wert, so wird der iterative Decodierungsvorgang abgebrochen. Es liegt damit ein Abbruchkriterium vor, das auf einer Schätzung der Qualität der Decodierung beruht und lediglich auf der empirischen Feststellung aufbaut, daß bei stark fehlerbehafteten Zeichensequenzen die Rauschvarianz bis zur die vollständige Fehlerbehebung ermöglichenden Iterationsschritt sehr hoch ist. Im übrigen ist der Rechenaufwand zur Bestimmung dieses Abbruchkriteriums sehr hoch.

Der Erfindung liegt somit die Aufgabe zugrunde, ein Verfahren und eine Anordnung zur Bestimmung eines adaptiven Abbruchkriteriums beim iterativen Decodieren multidimensional codierter Information anzugeben, das die oben genannten Nachteile vermeidet.

Diese Aufgabe wird durch das Verfahren nach den Merkmalen des Anspruchs 1 gelöst. In einem unabhängigen Anspruch wird eine Anordnung zur Durchführung des erfindungsgemäßen Verfahrens angegeben.

Der besondere erfinderische Aspekt liegt in der Nutzung der während des Prozesses der iterativen Decodierung zusätzlich gewonnenen Information (Extrinsic Information) zur Bestimmung des Abbruchs des Decodierungsverfahrens. Nach einer jeden Decodierung eines der Komponentencodes des multidimensionalen Codes kann die gewichtete Entscheidung (Soft Output) über jedes der zu decodierenden Informationszeichen (insbesondere Informationsbits bei digitalen Zeichen) als Summe der Extrinsic Information aus der jeweils letzten Decodierung eines jeden Komponentencodes der Kanalinformation sowie der eventuell vorhandenen a priori Information über das betreffende Informationsbit gebildet werden. Die Bestimmung der Näherung der relativen Entropie aus den gewichteten Entscheidungen zweier Teiliterationen, die dem vorgeschlagenen Abbruchkriterium zugrunde liegt, kann damit sowohl nach einem Teiliterationsschritt als auch nach einer vollständigen Iteration eingeleitet werden.

Das Verfahren zur Bestimmung eines adaptiven Abbruchkriteriums soll im folgenden kurz anhand informationstheoretischer Herleitungen erläutert werden. Es basiert im wesentlichen auf einer Näherung der relativen Entropie (Cross Entropy, Relative Entropy) $D(P\|Q)$ zweier Verteilungen P und Q, die ein Maß für den Unterschied der Verteilungen P und Q ist.

Sei $L_P^{(i)}(\hat{u}_k)$ der Soft Output über das decodierte Informationsbit $\hat{u}_k$ nach der i-ten Teiliteration der Decodierung eines n-dimensionalen "Turbo" Codes, der sich folgendermaßen zusammensetzt:

$$L_P^{(i)}(\hat{u}_k) = L_{e_k} \cdot y_k + L(\hat{u}_k) + \sum_{j=1}^{n} L_{e_j}^{(i)}(\hat{u}_k). \qquad (1)$$

Dabei bezeichnet $L_{ek} \cdot y_k$ die Kanalinformation, $L(\hat{u}_k)$ die a priori Information und $L_e^{(i)}(\hat{u}_k)$ die zum Zeitpunkt i aktuelle Extrinsic Information aus der Decodierung des j-ten Komponentencodes. $L_P^{(i)}(\hat{u}_k)$ charakterisiere die binäre Verteilung $P_k^{(i)}$. Die Verteilung $Q^{(i)}$ wird dann durch den L-Wert $L_Q^{(i)}(\hat{u}_k)$ charakterisiert, der sich von $L_P^{(i)}(\hat{u}_k)$ dadurch unterscheidet, daß zumindest ein Summand aus der Summe über die n Extrinsic Informationen aus einer vorhergenden Teiliteration $\xi(\xi<i)$ stammt.

Unter den Voraussetzungen, daß $sign(L_P^{(i)}(\hat{u}_k))=sign(L_Q^{(i)}(\hat{u}_k))$, $|L_P^{(i)}(\hat{u}_k)| \gg 1$, $|L_Q^{(i)}(\hat{u}_k)| \gg 1$, $|L_P^{(i)}(\hat{u}_k)| > |L_Q^{(i)}(\hat{u}_k)|$ und $|L_P^{(i)}(\hat{u}_k) - L_Q^{(i)}(\hat{u}_k)| \ll 1$ entspricht

$$\tilde{D}(P_k^{(i)} \| Q_k^{(i)}) = e^{-|L_Q^{(i)}(\hat{u}_k)|} \cdot |L_P^{(i)}(\hat{u}_k) - L_Q^{(i)}(\hat{u}_k)|^2 \qquad (2)$$

näherungsweise der Cross Entropy der Verteilungen $P^{(i)}$ und $Q^{(i)}$.

Setzt man weiter die statistische Unabhängigkeit der einzelnen Entscheidungen voraus, approximiert

$$\tilde{D}(P^{(i)} \| Q^{(i)}) = \sum_{(k)} \tilde{D}(P_k^{(i)} \| Q_k^{(i)}) \qquad (3)$$

die Cross Entropie $D(P\|Q)$ der i-ten Teiliteration, die, da $P^{(i)}$ von den L-Werten der i-ten Teiliteration und $Q^{(i)}$ neben den L-Werten der i-ten Teiliteration auch von den L-Werten von zumindest einer Teiliteration $\xi(\xi<i)$ abhängt, eine Maß für die Änderung in den Entscheidungen zweier Teiliterationen i und $\xi$ ist.

Da der Abbruch der iterativen Decodierung nach einer Teiliteration i idealerweise genau dann erfolgen soll, wenn auch weitere Teiliterationen keine Änderung der Ergebnisses der Decodierung bewirken, kann das Abbruchkriterium mit Hilfe von

$$\tilde{D}(P^{(i)} \| Q^{(i)})$$

wie folgt formuliert werden:

Die iterative Decodierung kann nach der Teiliteration i abgebrochen werden, falls

$$\tilde{D}(P^{(i)} \| Q^{(i)}) < S. \qquad (4)$$

Durch die Wahl des Schwellwertes S kann sowohl auf die Qualität, als auch auf die Komplexität der Decodierung Einfluß genommen werden.

Der besondere Vorteil dieser Vorgehensweise liegt darin, daß die zusätzlich gewonnene Information (Extrinsic Information) durch das bekannte Verfahren bereits erzeugt wird, also zusätzliche Berechnungsvorgänge entfallen.

Nach einer vorteilhaften Weiterbildung des erfindungsgemäßen Verfahrens wird der Vergleich der gewichteten Entscheidungen über die Informationsbits nach Vollendung eines kompletten Iterationsschritts unter Einbeziehung der aus der Decodierung aller Komponentencodes des mulitdimensionalen Codes gewonnen Extrinsic Information gebildet. Dadurch wird der Beitrag eines Iterationsschrittes vollständig ausgewertet und in das Abbruchkriterium integriert.

Die Berechnung der Näherung der relativen Entropie kann durch Verarbeitung der Extrinsic Information vorgenommen und das Ergebnis mit einem Schwellwert verglichen werden. Für den Fall, daß die relative Entropie kleiner als der Schwellwert ist, kann die iterative Decodierung abgebrochen werden - Anspruch 3. Das vorgeschlagene adaptive Abbruchkriterium schließt alle die Verfahren ein, die in der Abbruchbedingung (4) statt

$$\bar{D}(P^{(l)}\|Q^{(l)})$$

andere Näherungen der Cross Entropy, die Cross Entropy selbst oder andere Größen, die in ihren Eigenschaften der Cross Entropy ähnlich sind, verwenden. Zu der letzten Gruppe sind insbesondere die Größen zu zählen, die den Unterschied in den Ergebnissen der Decodierung zweier oder mehrerer verschiedener Teiliterationen hauptsächlich durch Differenzbildung der Soft Output-Werte oder durch Differenzbildung von Teilen der Soft Output-Werte evaluieren.

Die Festlegung eines Schwellwertes, mit dem die relative Entropie verglichen wird, stellt einen Kennwert für die Decodierungsqualität dar, der nach Art des Dienstes, dem die übertragene Information angehört, wählbar ist. Werden die Information innerhalb vorbestimmter Rahmen übertragen, kann im Sinne der Flexibilität des erfindungsgemäßen Verfahrens der Schwellwert für jeden Rahmen getrennt festgelegt werden.

Das im Rahmen des erfindungsgemäßen Verfahrens bestimmte Abbruchkriterium kann mit weiteren zusätzlichen Abbruchkriterien kombiniert werden. Dieses zusätzliche Abbruchkriterium kann z.B. eine festgelegte Anzahl von Iterationen sein, die eine maximal tolerierbare Decodierverzögerung markieren.

Ein unabhängiger Anspruch beschreibt einen Decodiermodul im Sinne des erfindungsgemäßen Verfahrens. Weitere vorteilhafte Weiterbildungen des erfindungsmäßen Verfahrens und des erfindungsgemäßen Decodiermoduls sind in den übrigen Unteransprüchen angegeben.

Das erfindungsgemäße Verfahren soll anhand eines Ausführungsbeispiels näher beschrieben werden.

Es zeigen

FIG 1    das Blockschaltbild eines Decodiermoduls im Sinne des erfindungsgemäßen Verfahrens, und

FIG 2    ein Blockschaltbild der Einrichtung innerhalb des Decoders, die einen Abbruch der iterativen Decodierung bewirkt.

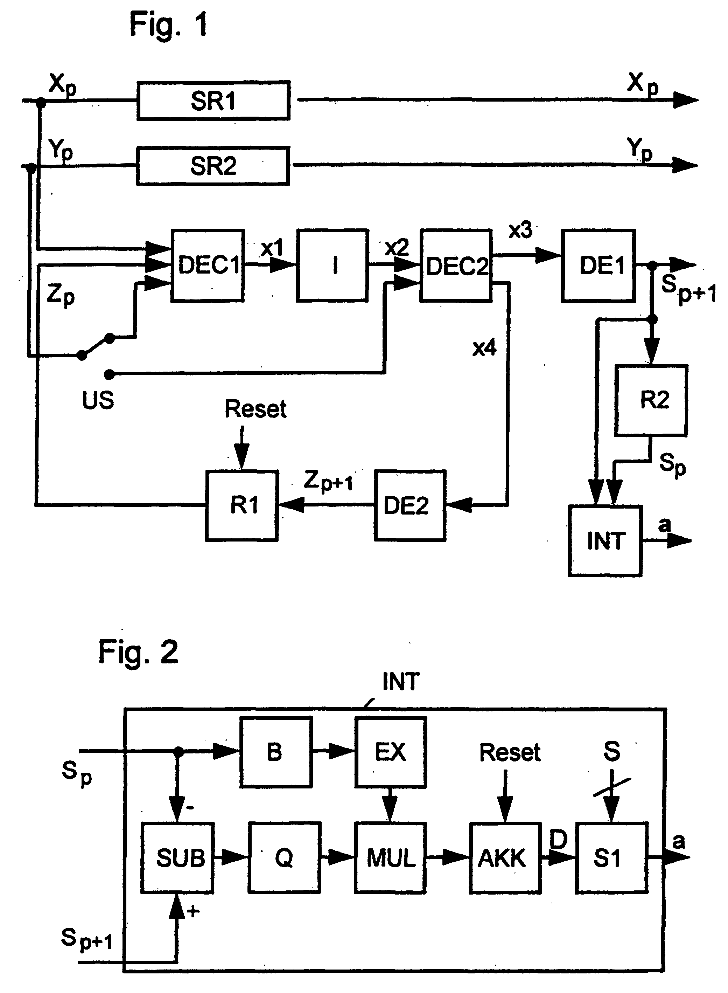

Der Decodiermodul in FIG 1 bewirkt einen Iterationsschritt im Sinne einer iterativen Decodierung der empfangenen Information. Im gewählten Beispiel erfolgt eine Rückkopplung einer bei der Decodierung erzeugten Extrinsic Information $Z_p$ (feedback-Verfahren). Es ist jedoch auch möglich, mehrere solcher Decodiermodule aneinanderzureihen (pipeline-Verfahren.

Der Modul besitzt drei Eingänge, für die die Information repräsentierenden Zeichen $X_p$, die Kontrollzeichen entsprechend der Kanalcodierung $Y_p$ und die im letzten Iterationsteilschritt erzeugte Extrinsic Information $Z_p$. Der Decodiermodul besitzt fünf Ausgänge, wobei die die Information repräsentierenden Zeichen $X_p$ über das Schieberegister SR1 und die Kontrollzeichen $Y_p$ über das Schieberegister SR2 verzögert werden und auch an den Ausgängen des Decodiermoduls anliegen. Die durch den aktuellen Iterationsschritt der iterative Decodierung gewonnene Extrinsic Information $Z_{p+1}$ bildet einen Ausgang des Decodiermoduls und wird über ein erstes Register R1 zum Eingang zurückgeführt, der Ausgang a liefert die Abbruchentscheidung und der Ausgang $S_{p+1}$ liefert nach der letzten Iteration eine gewichtete Entscheidung über die gesendete Information.

Ein erster Eingang eines ersten Decoders DEC1 ist mit dem die Information repräsentierenden Zeichen $X_p$ führenden Eingang des Decodiermoduls verbunden. Ein Ausgang des ersten Registers R1 führt dem ersten Decodierer DEC1 auf einen zweiten Eingang die während des letzten Iterationsteilschrittes gewonnene Extrinsic Information $Z_p$ zu. Diese Information $Z_p$ wird vor der ersten Iteration über einen Rücksetzeingang Reset des ersten Registers R1 auf einen neutralen Wert gesetzt.

Ein dritter Eingang des ersten Decodierers DEC1 ist mit dem ersten Kontakt eines zweistufigen Umschalters US verbunden. Der Umschalter US ist weiterhin mit dem die Kontrollzeichen $Y_p$ führenden Eingang des Decodiermoduls verbunden.

Ein Ausgang des ersten Decodierers DEC1 führt eine erste Zwischeninformation x1, die sowohl die Extrinsic Information $Z_p$ der Decodierung als auch die die Informationen repräsentierenden Zeichen $X_p$ enthält, einem Eingang eines Interleavers I zu. Im Interleaver I wird die erste Zwischeninformation x1 zu einer zweiten Zwischeninformation x2 verwürfelt.

Ein Ausgang des Interleavers I ist mit einem ersten Eingang eines zweiten Decodierers DEC2 verbunden, so daß die zweite Zwischeninformation x2 am zweiten Decodierer DEC2 vorliegt. Ein zweiter Eingang des zweiten Decodierers DEC2 ist mit einem zweiten Kontakt des Umschalters US verbunden. Der Umschalter US schaltet im gewählten Beispiel zwei seriell vorliegende Sequenzen von Kontrollzeichen $Y_p$ zeitrichtig auf die zwei Decodierer DEC1, DEC2 und fügt gegebenenfalls neutrale Zeichen ein. Es können sehr wohl auch parallele Leitungen unter Verzicht auf den Umschalter US für die Kontrollzeichen $Y_p$ gewählt werden.

Der zweite Decodierer DEC2 ist zum einen mit einem Eingang eines ersten Deinterleavers DE1 und zum anderen mit einem Eingang eines zweiten Deinterleavers DE2 verbunden. Der erste Deinterleaver DE1 stellt am Ausgang ein Signal $S_{p+1}$, der Soft Output der Iteration, zur Verfügung. Der Ausgang des zweiten Deinterleavers DE2 stellt eine die durch den aktuellen Iterationsschritt gewonnene Extrinsic Information repräsentierende vierte Zwischeninformation x4 bereit, die einem Eingang des ersten Registers R1 zugeführt wird.

Der Soft Output $S_{p+1}$ am Ausgang des ersten Deinterleavers DE1 wird sowohl an einen Eingang eines zweiten Registers R2 als auch an einen Eingang einer Einrichtung INT angelegt. Ein zweiter Eingang der Einrichtung INT ist mit dem Ausgang des zweiten Registers R2 verbunden. An einem Ausgang der den Abbruch des iterativen Decodierungsverfahrens bestimmenden Einrichtung INT liegt ein die Abbruchentscheidung repräsentierendes Signal a an.

Die Schieberegister SR1 und SR2 verzögern die die Information repräsentierenden Zeichen $X_p$ und die Kontrollzeichen $Y_p$, bis die durch den Iterationsschritt getroffenen Entscheidungen an den Ausgängen des Decodiermoduls vorliegen. Der Decodiermodul verarbeitet beispielsweise binäre Zeichen, wobei die Zeichen $X_p$, $Y_p$ und $Z_p$ als Bitsequenzen von n Bits zur Verfügung stehen.

Der erste Decodierer DEC1 korrespondiert mit dem ersten Codierer der Codiereinrichtung. Das Decodierungsergebnis des ersten Decodierers DEC1, die erste Zwischeninformation x1, wird dem Interleaver I zugeführt, der entsprechend einer Interleaver-Matrix die Bits innerhalb der Zeichensequenz verwürfelt. Diese verwürfelte Zeichensequenz ist die zweite Zwischeninformation x2, die im zweiten Decoder DEC2 zusammen mit dem entsprechenden Teil der Kontrollzeichensequenz $Y_p$ decodiert wird. Der zweite Decodierers DEC2 korrespondiert mit dem zweiten Codierers der Codiereinrichtung, der den zugehörigen Teil der Kontrollzeichensequenz $Y_p$ generiert. Der zweite Decoder DEC2 erzeugt die dritte Zwischeninformation x3, die nach dem ersten Deinterleaver DE1 dem Soft Output $S_{p+1}$ der Iteration entspricht. Der erste Decodierer DEC1 und der zweite Decodierer DEC2 müssen nicht zwangsläufig die gleichen Decodierungsverfahren verwenden. Sie müssen lediglich den zugehörigen Codierern der Codiereinrichtung entsprechen.

Die ebenfalls durch den zweiten Decodierer DEC2 erzeugte vierte Zwischeninformation x4 wird nach einem Deinterleaving im zweiten Deinterleaver DE2 als Extrinsic Information $Z_{p+1}$ des aktuellen Iterationsschrittes in das erste Register R1 geschrieben, so daß sie als Extrinsic Information $Z_p$ für den nächsten Iterationsschritt zur Verfügung steht. Der am Ausgang des zweiten Deinterleavers DE1 zur Verfügung gestellte Soft Output $S_{p+1}$ wird in das zweite Register R2 geschrieben. Das zweite Register R2 ist so aufgebaut und getaktet, daß an der Einrichtung zur Entscheidung über den Abbruch INT der Soft Output $S_p$ und $S_{p+1}$ zweier aufeinanderfolgender Iterationsschritte anliegt. Durch diese Einrichtung INT wird ein Abbruchsignal a erzeugt.

In FIG 2 wird im folgenden diese Einrichtung zur Bestimmung des Abbruchs INT detaillierter beschrieben. Ein Subtrahierglied SUB ist mit seinem subtrahierenden Eingang mit dem im vorhergehenden Iterationsschritt erzeugten Soft Output $S_p$ und über seinen addierenden Eingang mit dem im aktuellen Iterationsschritt erzeugten Soft Output $S_{p+1}$ verbunden. Ein Ausgang des Subtrahiergliedes SUB mit dem Signal $S_{p+1}-S_p$ hat eine Verbindung mit einem Quadrierer Q, der das Signal $(S_{p+1}-S_p)$ zum Quadrat erzeugt. Das Signal $(S_{p+1}-S_p)^2$ wird auf ein Multiplizierglied MUL geführt. In diesem Multiplizierglied MUL wird dazu ein Signal multipliziert, das durch eine Betragsbildung des im vorhergehenden Iterationsschritt erzeugten Soft Outputs $S_{p+1}$ in einem Mittel zur Betragsbildung B und durch Berechnung einer Expotentialfunktion in einem Mittel zur Expotentialbildung EX erzeugt wurde. Der Quadrierer Q und das Mittel zur Expotentialfunktionsbildung EX können durch entsprechende Rechenroutinen oder durch Tabellen mit nichtlinear quantisierten Eingangs- und Ausgangswerten realisiert werden. Dementsprechend kann auch das Multipllizierglied MUL vereinfacht werden.

In einem mit dem Ausgang des Multiplizierglieds MUL verbundenen Akkumulator AKK wird das Multiplikationsergebnis aufsummiert. Am Ausgang des Akkumulators AKK liegt somit die relative Entropie D der aktuellen Iteration näherungsweise vor. Die relative Entropie D wird damit einsprechend der Gleichung:

$$D = e^{\left|-S_p\right|} \cdot \left|S_{p+1}-S_p\right|^2 \tag{5}$$

approximiert.

In einem auf den Akkumulator AKK folgenden Schwellwertschalter S1 wird die aufsummierte relative Entropie D mit einem einstellbaren Schwellwert S verglichen. Nach jedem Iterationsschritt wird der Akkumulator AKK zurückgesetzt, so daß bei der Entscheidung über den Abbruch der iterativen Decodierung die relative Entropie D des letzten Iterationsschrittes mit dem Schwellwert S verglichen wird. Falls die relative Entropie D kleiner dem Schwellwert S ist, wird ein Abbruchsignal a an einem Ausgang des Schwellwertschalters S1 erzeugt. Dieses Abbruchsignal a wird durch den Decodiermodul ausgewertet und nach Abbruch der Decodierung der Soft Output $S_{p+1}$ nach der letzten Iteration nachfolgenden Modulen zur Verfügung gestellt - nicht dargestellt.

Vorteilhafterweie kann nach jedem Akkumulationsschritt bereits geprüft werden, ob der Schwellwert S überschritten wird. Ist dies der Fall, kann die Berechnung der relativen Entropie D abgebrochen werden. Zur Realisierung der Einrichtung über die Bestimmung des Abbruchs der iterativen Decodierung INT können auch andere Berechnungsverfahren des Abbruchsignals a unter Verwendung von der relativen Entropie D ähnlichen Größen eingesetzt werden.

**Patentansprüche**

1. Verfahren zur Bestimmung eines adaptiven Abbruchkriteriums beim iterativen Decodieren multidimensional codierter Information,
   bei dem nach einem Iterationsteilschritt eine erste gewichtete Entscheidung ($S_{p+1}$), der Soft Output, über die zu decodierende Information mit einer zweiten gewichteten Entscheidung ($S_p$), die aus einer zur ersten gewichteten Entscheidung ($S_{p+1}$) unterschiedlichen Kombination von Teilergebnissen vorangegangener Iterationsteilschritte gewonnen wird, verglichen wird und
   in Abhängigkeit vom Vergleichsergebnis die iterative Decodierung abgebrochen wird.

2. Verfahren nach Anspruch 1,
   **dadurch gekennzeichnet,**
   **daß** die dem Vergleich zugrundeliegenden gewichteten Entscheidungen ($S_{p+1}$, $S_p$) nach Vollendung eines kom-pletten Iterationsschrittes aus den der Dimension des Codes entsprechenden Komponenten des Codes gebildet werden.

3. Verfahren nach einem der Ansprüche 1 oder 2,
   **dadurch gekennzeichnet,**
   **daß** die dem Vergleich zugrundeliegenden gewichteten Entscheidungen ($S_{p+1}$, $S_p$) zur Berechnung einer relativen Entropie (D) verwendet werden,
   **daß** die relative Entropie (D) mit einem Schwellwert (S) verglichen wird und
   **daß** für den Fall, daß die relative Entropie (D) kleiner als der Schwellwert (S) ist, die iterative Decodierung abgebrochen wird.

4. Verfahren nach Anspruch 3,
   **dadurch gekennzeichnet,**
   **daß** die Decodierung abgebrochen wird, falls die relative Entropie (D) kleiner als der Schwellwert (S) ist oder die Anzahl der bereits vollzogenen Iterationen einer vorbestimmten Zahl entspricht.

5. Verfahren nach Anspruch 3 oder 4,
   **dadurch gekennzeichnet,**
   **daß** der Schwellwert (S) in Abhängigkeit von der gewünschten Übertragungsqualität und der mittleren Decodierverzögerung einstellbar ist.

6. Verfahren nach einem der Ansprüche 3 bis 5,
   **dadurch gekennzeichnet,**
   **daß** die zu decodierende Information innerhalb mehrerer Rahmen übertragen wird und der Schwellwert (S) für jeden Rahmen getrennt festgelegt wird.

7. Verfahren nach Anspruch 3 bis 6,
   **dadurch gekennzeichnet,**
   **daß** anstelle der relativen Entropie (D) Näherungen derselben verwendet werden.

8. Verfahren nach Anspruch 3 bis. 6,
   **dadurch gekennzeichnet,**
   **daß** zum Vergleich der gewichteten Entscheidungen ($S_{p+1}$, $S_p$) anstelle der relativen Entropie (D) andere Größen, die in ihren Eigenschaften ähnlich sind oder durch Differenzbildung der gewichteten Entscheidungen ($S_{p+1}$, $S_p$) oder Teilen davon gewonnen werden, verwendet werden.

9. Verfahren nach Anspruch 3 bis 6,
   **dadurch gekennzeichnet,**
   **daß** zur Bestimmung der relativen Entropie (D) oder Näherungen davon Tabellen mit nichtlinear quantisierten Eingangs- und Ausgangswerten eingesetzt werden.

**10.** Verfahren nach einem der vorhergehenden Ansprüche,
**dadurch gekennzeichnet,**
**daß** zusätzliche Abbruchkriterien in die Entscheidung über den Abbruch der iterativen Decodierung einbezogen werden.

**11.** Decodiermodul mit Bestimmung eines adaptiven Abbruchkriteriums beim iterativen Decodieren multidimensional codierter Information,
mit Mitteln zur Ermittelung und Speicherung von gewichteten Entscheidungen ($S_{p+1}$, $S_p$) nach einem Iterationsteilschritt, mit Mitteln zum Vergleichen der gewichteten Entscheidungen ($S_{p+1}$, $S_p$) und
mit Mitteln zur Veranlassung eines Abbruchs der iterativen Decodierung in Abhängigkeit vom Vergleichsergebnis.

**12.** Decodiermodul nach Anspruch 11,
**dadurch gekennzeichnet,**
**daß** die Mittel zur Ermittlung und Speicherung der gewichteten Entscheidungen ($S_{p+1}$, $S_p$) derart ausgestaltet sind,

- **daß** die erste gewichtete Entscheidung ($S_{p+1}$) aus dem aktuellen Iterationsschritt gewonnen wird,
- **daß** die zweite gewichtete Entscheidung ($S_p$) aus einer zur ersten gewichteten Entscheidung ($S_{p+1}$) unterschiedlichen Kombination von Teilergebnissen vorangegangener Iterationsteilschritte gewonnen wird,

**daß** die Mittel zum Vergleich der gewichteten Entscheidungen ($S_{p+1}$, $S_p$) so ausgestaltet sind,

- **daß** die relative Entropie (D) aus den gewichteten Entscheidungen ($S_{p+1}$, $S_p$) bestimmt wird, die relative Entropie (D) mit einem Schwellwert (S) verglichen wird und

für den Fall, daß die relative Entropie (D) kleiner als der Schwellwert (S) ist, die iterative Decodierung durch die Mittel zur Veranlassung eines Abbruchs der iterativen Decodierung abgebrochen wird.

**13.** Decodiermodul nach Anspruch 12,
**dadurch gekennzeichnet,**
**daß** Mittel zum Einstellen des Schwellwertes (S) vorgesehen sind, so daß für in Rahmen übertragene Information der Schwellwert (S) für jeden Rahmen getrennt eingestellt werden kann.

**14.** Decodiermodul nach Anspruch 12 oder 13,
**dadurch gekennzeichnet,**
**daß** die Mittel zur Veranlassung des Abbruchs der iterativen Decodierung in Abhängigkeit vom Vergleichsergebnis ebenfalls nach einer durch Einstellmittel festgelegten Maximalanzahl von Iterationen den Abbruch der iterativen Decodierung bewirken.

**Claims**

**1.** Method for determining an adaptive termination criterion in the iterative decoding of multidimensionally coded information, in which after one iteration substep a first weighted decision ($S_{p+1}$), the soft output, is compared via the information to be decoded with a second weighted decision ($S_p$), which is obtained from a combination, differing from the first weighted decision ($S_{p+1}$), of partial results of preceding iteration substeps, and the iterative decoding is terminated as a function of the result of the comparison.

**2.** Method according to Claim 1, **characterized in that** the weighted decisions ($S_{p+1}$, $S_p$) on which the comparison is based are formed after completion of a complete iteration step from the components of the code which correspond to dimension of the code.

**3.** Method according to one of Claims 1 or 2, **characterized in that** the weighted decisions ($S_{p+1}$, $S_p$) on which the comparison is based are used to calculate a relative entropy (D), **in that** the relative entropy (D) is compared with a threshold value (S), and **in that** the iterative decoding is terminated if the relative entropy (D) is smaller than the threshold value (S).

**4.** Method according to Claim 3, **characterized in that** the decoding is terminated if the relative entropy (D) is smaller than the threshold value (S), or the number of iterations already completed corresponds to a predetermined number.

**5.** Method according to Claim 3 or 4, **characterized in that** the threshold value (S) can be set as a function of the desired transmission quality and the mean decoding delay.

**6.** Method according to one of Claims 3 to 5, **characterized in that** the information to be decoded is transmitted within a plurality of frames, and the threshold value (S) is fixed separately for each frame.

**7.** Method according to Claims 3 to 6, **characterized in that** instead of the relative entropy (D) approximations of the latter are used.

**8.** Method according to Claims 3 to 6, **characterized in that**, instead of the relative entropy (D), other variables which are similar in their properties or are obtained by subtracting the weighted decisions ($S_{p+1}$, $S_p$) or parts thereof are used to compare the weighted decisions ($S_{p+1}$, $S_p$).

**9.** Method according to Claims 3 to 6, **characterized in that** tables with nonlinearly quantized input and output values are used to determine the relative entropy (D) or approximations thereof.

**10.** Method according to one of the preceding claims, **characterized in that** additional termination criteria are incorporated into the decision on the termination of the iterative decoding.

**11.** Decoding module with determination of an adaptive termination criterion in the iterative decoding of multidimensionally coded information, having means for determining and storing weighted decisions ($S_{p+1}$, $S_p$) after an iteration substep, having means for comparing the weighted decisions ($S_{p+1}$, $S_p$), and having means for prompting a termination of the iterative decoding as a function of the result of the comparison.

**12.** Decoding module according to Claim 11, **characterized in that** the means for determining and storing the weighted decisions ($S_{p+1}$, $S_p$) are configured in such a way

-   that the first weighted decision ($S_{p+1}$) is obtained from the current iteration step, and
-   that the second weighted decision ($S_p$) is obtained from a combination, differing from the first weighted decision ($S_{p+1}$), of partial results of preceding iteration substeps,

and **in that** the means for comparing the weighted decisions ($S_{p+1}$, $S_p$) are configured in such a way

-   that the relative entropy (D) is determined from the weighted decisions ($S_{p+1}$, $S_p$), the relative entropy (D) is compared with a threshold value (S) and, if the relative entropy (D) is smaller than the threshold value (S), the iterative decoding is terminated by the means for prompting a termination of the iterative decoding.

**13.** Decoding module according to Claim 12, **characterized in that** means for setting the threshold value (S) are provided such that for information transmitted in frames the threshold value (S) can be set separately for each frame.

**14.** Decoding module according to Claim 12 or 13, **characterized in that** the means for prompting the termination of the iterative decoding effect the termination of the iterative decoding as a function of the result of the comparison, likewise after a maximum number of iterations fixed by a setting means.

## Revendications

**1.** Méthode pour déterminer un critère d'interrupteur adaptatif lors du décodage itératif d'information codée de façon multidimensionnelle,
dans laquelle après une étape d'itération partielle, une première décision pondérée ($S_{p+1}$), le Soft Output, à l'aide de laquelle l'information devant être décodée est comparée, avec une deuxième décision pondérée ($S_p$), extraite d'une combinaison différente par rapport à la première décision pondérée ($S_{p+1}$), d'étapes d'itération partielles devancées par des résultats partiels, et
le décodage itératif est interrompu en fonction du résultat de la comparaison.

**2.** Méthode selon la revendication 1, **caractérisée en ce que** les décisions pondérées à la base de la comparaison ($S_{p+1}$, $S_p$) sont formées après l'achèvement d'une étape d'itération complète à partir des composants du code correspondant à la dimension du code.

3. Méthode selon l'une des revendications 1 ou 2, **caractérisée en ce que** les décisions pondérées à la base de la comparaison ($S_{p+1}$, $S_p$) sont utilisées pour calculer une entropie (D) relative,

   **en ce que** l'entropie relative (D) est comparée à une valeur seuil (S) et

   **en ce qu'**au cas où l'entropie (D) relative est inférieure à la valeur seuil (S), le décodage itératif est interrompu.

4. Méthode selon la revendication 3, **caractérisée en ce que** le décodage est interrompu au cas où l'entropie (D) relative est inférieure à la valeur seuil (S) ou si le nombre des itérations déjà effectué correspond à un nombre prédéfini.

5. Méthode selon l'une des revendications 3 ou 4, **caractérisée en ce que** la valeur seuil (S) est réglable en fonction de la qualité de transmission souhaitée et du retard moyen du décodeur.

6. Méthode selon l'une des revendications 3 à 5, **caractérisée en ce que** l'information devant être décodée est transmise à l'intérieur de plusieurs trames et la valeur seuil (S) est déterminée séparément pour chaque trame.

7. Méthode selon l'une des revendications 3 à 6, **caractérisée en ce que** l'on utilise des approximations de l'entropie (D) relative à la place de celle-ci.

8. Méthode selon l'une des revendications 3 à 6, **caractérisée en ce que** pour comparer les décisions pondérées ($S_{p+1}$, $S_p$) à la place de l'entropie (D) relative, on utilise d'autres grandeurs, qui sont similaires dans leurs propriétés ou sont extraites, par la formation de différence des décisions pondérées ($S_{p+1}$, $S_p$) ou des parties de celles-ci.

9. Méthode selon l'une des revendications 3 à 6, **caractérisée en ce que** des tableaux avec des valeurs d'entrée et de sortie non linéaires quantifiées sont utilisés pour déterminer l'entropie relative (D) ou des approximations de celle-ci.

10. Méthode selon l'une des revendications précédentes, **caractérisée en ce que** les critères d'interruption supplémentaires sont intégrés à la décision sur l'interruption du décodage itératif.

11. Module de décodage avec une détermination d'un critère d'interrupteur adaptatif lors du décodage itératif d'infirmation codée de façon multidimensionnelle, avec des moyens pour déterminer et mémoriser des décisions pondérées ($S_{p+1}$, $S_p$) d'après une étape d'itération partielle,

    des moyens pour comparer les décisions pondérées ($S_{p+1}$, $S_p$) et

    des moyens pour déterminer une interruption du décodage itératif en fonction du résultat de la comparaison.

12. Module de décodage selon la revendication 11, **caractérisé en ce que** les moyens pour déterminer et mémoriser les décisions pondérées ($S_{p+1}$, $S_p$) sont réalisés de telle sorte que,

    - la première décision pondérée ($S_{p+1}$) est extraite de l'étape d'itération partielle actuelle,
    - la deuxième décision pondérée ($S_p$) est extraite d'une combinaison différente de la première décision pondérée ($S_{p+1}$) de résultats partiels des étapes d'itération partielles,

    **en ce que** les moyens pour comparer les décisions pondérées ($S_{p+1}$, $S_p$) sont réalisés de telle sorte que

    - l'entropie (D) relative est déterminée à partir des décisions ($S_{p+1}$, $S_p$) pondérées, l'entropie (D) relative étant comparée à une valeur seuil (S) et

    au cas où l'entropie (D) relative est inférieure à la valeur seuil (S), le décodage itératif est interrompu par des moyens pour ordonner une interruption du décodage itératif.

13. Module de décodage selon la revendication 12, **caractérisé en ce que** des moyens pour régler la valeur seuil (S) sont prévus, de sorte que la valeur seuil (S) peut être réglée séparément pour chaque trame pour l'information transmise dans des trames.

14. Module de décodage selon l'une des revendications 12 ou 13, **caractérisé en ce que** les moyens pour ordonner l'interruption du décodage itératif en fonction du résultat de la comparaison effectuent également l'interruption du décodage itératif selon un nombre maximal d'itérations fixé par des moyens de réglage.

# Fig. 1

# Fig. 2